# EUROPEAN PATENT SPECIFICATION

(11) **EP 2 887 401 B1**
(45) Date of publication and mention of the grant of the patent: **22.01.2020**
(21) Application number: 13879583.6
(22) Date of filing: 13.08.2013
(51) Int. Cl.: H01L 29/78, H01L 29/423, H01L 29/12, H01L 21/336

(54) **SEMICONDUCTOR DEVICE**
HALBLEITERBAUELEMENT
DISPOSITIF À SEMI-CONDUCTEURS

(30) Priority: 17.08.2012 JP 2012181159
(43) Date of publication of application: 24.06.2015
(60) Divisional application: 19217793.9
(73) Proprietor: Rohm Co., Ltd., Kyoto-shi, Kyoto 615-8585 (JP)
(72) Inventor: NAKANO, Yuki, Kyoto-shi, Kyoto 615-8585 (JP); NAKAMURA, Ryota, Kyoto-shi, Kyoto 615-8585 (JP); SAKAIRI, Hiroyuki, Kyoto-shi, Kyoto 615-8585 (JP)
(74) Representative: Witte, Weller & Partner Patentanwälte mbB
(86) International application number: PCT/JP2013/071876
(87) International publication number: WO 2014/027662

(56) References cited:
- EP-A2- 0 676 814
- JP-A- H09 307 101
- JP-A- H10 125 905
- JP-A- H10 154 810
- JP-A- 2008 294 210
- US-A- 5 723 376
- US-A1- 2002 167 046
- US-A1- 2004 173 845
- US-A1- 2007 075 362
- US-A1- 2009 272 982
- US-B1- 6 455 378

## Description

### TECHNICAL FIELD

The present invention relates to a semiconductor device that has a trench-gate structure.

### BACKGROUND ART

For example, a semiconductor device of Patent Document 1 includes a SiC substrate, an n type high-resistivity layer formed on the SiC substrate, a p well layer formed on the n type high-resistance layer, an n⁺ emitter region formed at a surface part of the p well layer, a p⁺ contact region that passes through the n⁺ emitter region and reaches the p well layer, a trench that passes through the p well layer from a surface of the n⁺ emitter region and reaches the n type high-resistance layer, a gate oxide film formed at an inner surface of the trench, and a polysilicon gate electrode embedded in the trench.

### RELATED ART DOCUMENT

### PATENT DOCUMENT

Patent Document 1, Japanese Patent Application Publication No. 2008-294210

Document US 2004/0173845 A1 discloses a method for manufacturing a semiconductor device, including the steps of: forming a trench in a substrate; forming a conductive film in the trench through an insulation film; and annealing the substrate at an annealing temperature after the step of forming the conductive film so that a damage in the insulation film is removed at the annealing temperature. From US 2002/0167046 A1, a trench-gate type transistor is known, which has a gate insulating film formed on an inner wall of a trench. The gate insulating film includes a first portion located on a wall of the trench and a second portion located on upper and bottom portions of the trench. The first portion includes a first oxide film, a nitride film, and a second oxide film. The second portion includes only an oxide film and is thicker than the first portion. Accordingly, electric field concentration on upper and lower corner portions of the trench can be reduced to improve the withstand voltage. In addition, an end of the trench may have an insulation layer that is thicker than the first portion. Document EP 0 676 814 A2 discloses a SiC trench gate transistor with the gate oxide layer, formed by thermal oxidation, having a thickness on the bottom of the trench and on the surface of the semiconductor layer greater than the thickness on the side surface of the trench.

### SUMMARY OF THE INVENTION

### PROBLEM TO BE SOLVED BY THE INVENTION

The invention is defined by a semiconductor device according to claim 1. In the following only the embodiment indicated as second embodiment pertains to the invention. The embodiments indicated as first, third and fourth embodiments are useful to understand the invention.

A semiconductor device useful to understand the present invention includes a semiconductor layer that has a structure in which a first conductivity type drain layer, a second conductivity type channel layer, and a first conductivity type source layer are layered in the stated order and that has its surface at which the source layer is exposed, a gate trench that passes through the source layer and through the channel layer from the surface of the semiconductor layer, a deepest part of the gate trench reaching the drain layer, a gate insulating film formed conformal to an inner surface of the gate trench and the surface of the semiconductor layer, and a gate electrode embedded inside the gate trench interposed by the gate insulating film, and a part of the gate insulating film in contact with the surface of the semiconductor layer is formed thicker than a part of the gate insulating film in contact with the channel layer at a side surface of the gate trench.

According to this arrangement, it is possible to allow the gate electrode to reliably overlap with the source layer even if a material outside the gate trench is excessively etched after embedding a material of the gate electrode in the gate trench. This makes it possible to manufacture a semiconductor device capable of excellently performing a transistor operation, and hence makes it possible to improve a yield. Additionally, the restraint of the thickening of a part of the gate insulating film in contact with the channel layer makes it possible to restrain a decrease in amount of carriers induced near the side surface of the gate trench in the channel layer. As a result, it is possible to restrain an increase in channel resistance, and hence is possible to maintain the reliability of performance.

In an embodiment of the invention, a part of the gate insulating film in contact with a bottom surface of the gate trench is formed thicker than the part thereof in contact with to the channel layer.

According to this arrangement, it is possible to lessen the concentration of an electric field on the bottom portion of the gate trench, and therefore it is possible to improve the reliability of performance.

The gate electrode has an extension portion extending upwardly from the surface of the semiconductor layer. In this case, an upper surface of the extension portion is positioned at a place in a thickness direction of the part of the gate insulating film in contact with the surface of the semiconductor layer.

Additionally, if the gate trench is formed with a constant width from the bottom surface thereof to an an opening end thereof, the gate insulating film may have a constant thickness in the part in contact with the channel layer and in a part in contact with the source layer at the side surface of the gate trench.

In accordance with the invention, the gate trench includes an upper edge that is formed at the opening end of the gate trench and that has an oblique surface continuous with the surface of the semiconductor layer as a part of the side surface, and the gate insulating film includes an overhang portion that projects to an inside of the gate trench in the upper edge.

According to this arrangement, the overhang portion is formed at the upper edge of the gate trench, and therefore it is possible to improve the withstanding pressure of the gate insulating film in the upper edge. Therefore, it is possible to prevent the gate insulating film from causing an insulation breakdown at the upper edge even if an electric field concentrates at the upper edge when the gate is turned on. As a result, it is possible to improve reliability with respect to a gate ON-state voltage. Additionally, it is possible to lessen the concentration of an electric field by dispersing the electric field applied onto the upper edge when the gate is turned on.

In an embodiment not belonging to the invention, the gate trench includes an upper edge that is formed at the opening end of the gate trench and that has a circular surface continuous with the surface of the semiconductor layer as a part of the side surface, and the gate insulating film includes an overhang portion that projects to an inside of the gate trench in the upper edge.

According to this arrangement, the overhang portion is formed at the upper edge of the gate trench, and therefore it is possible to improve the withstanding pressure of the gate insulating film in the upper edge. Therefore, it is possible to prevent the gate insulating film from causing an insulation breakdown at the upper edge even if an electric field concentrates at the upper edge when the gate is turned on. As a result, it is possible to improve reliability with respect to a gate ON-state voltage. Additionally, it is possible to lessen the concentration of an electric field by dispersing the electric field applied onto the upper edge when the gate is turned on.

In accordance with the invention, the overhang portion has a circular shape swelling toward the inside of the gate trench when cross-sectionally viewed in a cutting plane that crosses the gate trench in a width direction. In this case, the gate electrode has a constricted portion that is selectively concaved in a circular shape along the overhang portion when cross-sectionally viewed in the cutting plane.

According to this arrangement, it is possible to evenly disperse the electric field to the whole of the overhang portion.

The semiconductor device may further include an interlayer film formed on the semiconductor layer so as to cover the part of the gate insulating film in contact with the surface of the semiconductor layer, and the interlayer film may have a contact hole by which the source layer is selectively exposed.

The source layer may have a thickness of from 1 µm to 10 µm. Additionally, the semiconductor layer is made of silicon carbide (SiC).

### BRIEF DESCRIPTION OF THE DRAWINGS

[FIG. 1] FIG. 1 is a schematic cross-sectional view of a semiconductor device according to a first embodiment.
[FIG. 2] FIG. 2 is a schematic cross-sectional view of a semiconductor device according to a second embodiment corresponding to the present invention.
[FIG. 3] FIG. 3 is a schematic cross-sectional view of a semiconductor device according to a third embodiment.
[FIG. 4] FIG. 4 is a schematic cross-sectional view of a semiconductor device according to a fourth embodiment.
[FIG. 5] FIG. 5 is a flowchart to describe a method for manufacturing the semiconductor device.
[FIG. 6] FIG. 6 is a view to describe a step of forming an oblique surface at an upper edge.
[FIG. 7] FIG. 7 is a view to describe a step of forming a circular surface at the upper edge.

### DETAILED DESCRIPTION OF THE EMBODIMENT

An embodiment of the present invention will be hereinafter described in detail with reference to the accompanying drawings.

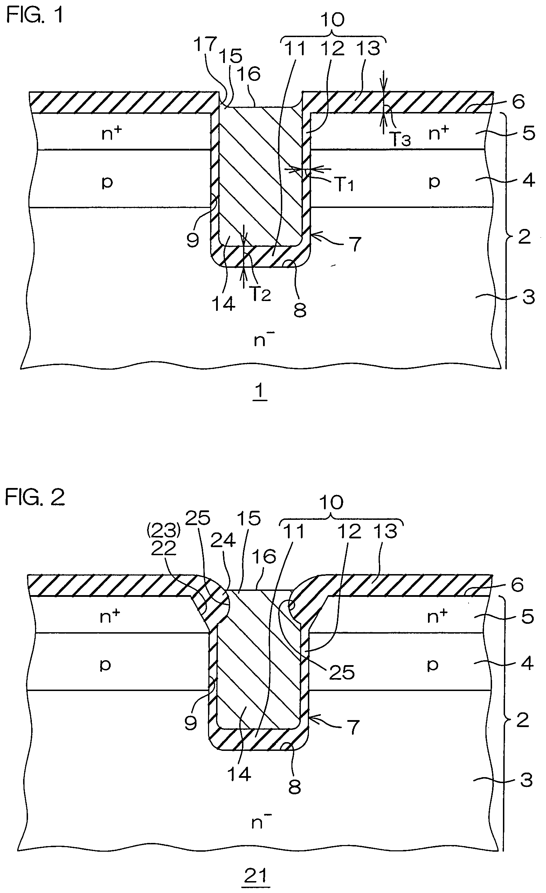

FIG. 1 is a schematic cross-sectional view of a semiconductor device 1 according to a first embodiment.

The semiconductor device 1 includes a power MOSFET (Metal-Oxide-Semiconductor Field Effect Transistor) element (individual element) that uses SiC (silicon carbide). The semiconductor device 1 has a SiC substrate 2 that is one example of a semiconductor layer of the present invention.

The SiC substrate 2 has a structure in which an n⁻ type drain layer 3, a p type channel layer 4, and an n⁺ type source layer 5 are stacked together in this order, and the n⁺ type source layer 5 is exposed to its surface 6. For example, N (nitrogen), P (phosphorus), As (arsenic), etc., can be used as an n type dopant (the same applies hereinafter), and, for example, B (boron), Al (aluminum), etc., can be used as a p type dopant.

The n⁻ type drain layer 3 has a thickness of from 1 µm to 100 µm, and has a dopant concentration of from 1×10¹⁵ cm⁻³ to 1×10¹⁷ cm⁻³. The p type channel layer 4 has a thickness of from 0.1 µm to 1 µm, and has a dopant concentration of from 1×10¹⁶ cm⁻³ to 1×10²⁰ cm⁻³. The n+ type source layer 5 has a thickness of from 0.05 µm to 0.5 µm, and has a dopant concentration of from 1×10¹⁸ cm⁻³ to 1×10²¹ cm⁻³.

A gate trench 7 is formed in the SiC substrate 2. The gate trench 7 passes through the n⁺ type source layer 5 and through the p type channel layer 4 from the surface 6 of the SiC substrate 2, and its deepest part reaches the n⁻ type drain layer 3. In the present embodiment, the gate trench 7 is formed with a predetermined width from a bottom surface 8 to its opening end. In other words, the distance between side surfaces 9 facing each other in the gate trench 7 is constant at any position in the depth direction of the gate trench 7.

A gate insulating film 10 is disposed on the inner surface (i.e., the bottom surface 8 and the side surface 9) of the gate trench 7 and on the surface 6 of the SiC substrate 2. The gate insulating film 10 is made of an insulating material such as silicon oxide (SiO₂). In the present embodiment, the gate insulating film 10 is formed such that its one surface and the other surface follow the inner surface (i.e., the bottom surface 8 and the side surface 9) of the gate trench 7 and the surface 6 of the SiC substrate 2, respectively.

The gate insulating film 10 integrally includes a bottom insulating film 11 on the bottom surface 8 of the gate trench 7, a side insulating film 12 on the side surface 9, and a plane insulating film 13 on the surface 6 of the SiC substrate 2. The insulating films 11 to 13 each of which is a constituent of the gate insulating film 10 differ in thickness from each other. The plane insulating film 13 and the bottom insulating film 11 are thicker than the side insulating film 12. More specifically, the thickness T₁ of the side insulating film 12 is 0.010 µm to 0.200 µm, whereas the thickness T₂ of the bottom insulating film 11 and the thickness T₃ of the plane insulating film 13 are 0.05 µm to 0.5 µm and 0.05 µm to 0.5 µm, respectively. Within the range mentioned above, each of the insulating films 11 to 13 has a constant thickness with respect to a surface with which each insulating film is in contact.

A gate electrode 14 is embedded inside the gate trench 7 with the gate insulating film 10 therebetween. The gate electrode 14 is made of a conductive material such as polysilicon. In the present embodiment, the gate electrode 14 integrally has an extension portion 15 that extends upwardly from the surface 6 of the SiC substrate 2. The extension portion 15 is formed such that its upper surface 16 is positioned at a middle in the thickness direction of the plane insulating film 13. Particularly, in the extension portion 15, an outer peripheral part 17 near the side surface 9 of the gate trench 7 is warped more upwardly than in its inner area.

FIG. 2, FIG. 3, and FIG. 4 are schematic cross-sectional views of semiconductor devices 21, 31, and 41 according to second, third, and fourth embodiments, respectively. In FIG. 2 to FIG. 4, the same reference sign is given to a component equivalent to each component shown in the figure mentioned earlier than in the remaining figures.

As shown in FIG. 2, the semiconductor device 21 of the second embodiment corresponding to the present invention additionally includes an upper edge 23 having an oblique surface 22, which is a part of the side surface 9, continuous with the surface 6 of the SiC substrate 2 at the opening end of the gate trench 7. The side insulating film 12 includes an overhang portion 24 that is selectively thicker than other parts of the side insulating film 12 so as to protrude to the inside of the gate trench 7 in the upper edge 23.

The overhang portion 24 has a circular shape swelling toward the inside of the gate trench 7 when cross-sectionally viewed in a cutting plane that crosses the gate trench 7 in the width direction. As a result, the gate electrode 14 has a constricted portion 25 that is selectively concaved in a circular shape along the overhang portion 24 from both sides in the width direction of the gate trench 7 in the depth direction of the gate trench 7 from the upper surface 16.

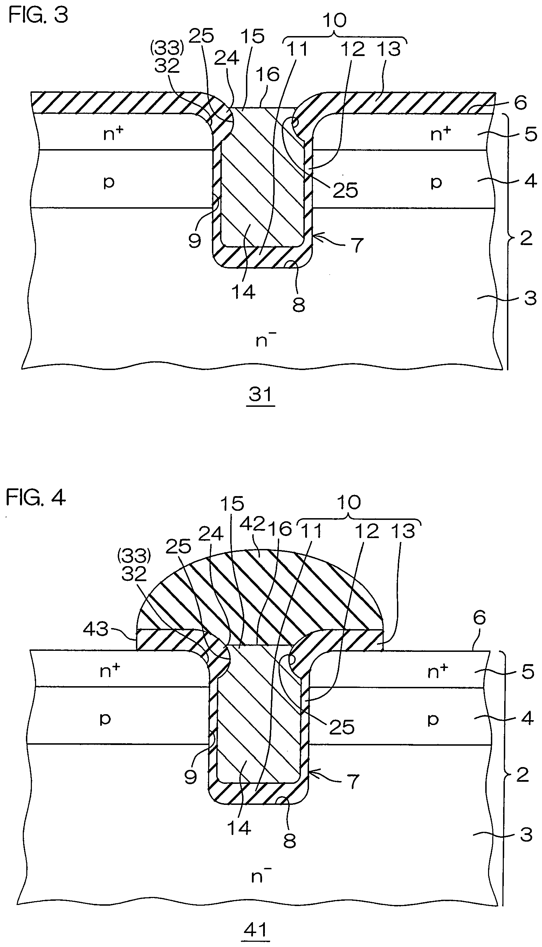

The semiconductor device 31 of the third embodiment shown in FIG. 3 includes an upper edge 33 that has a circular surface 32, which is a part of the side surface 9, continuous with the surface 6 of the SiC substrate 2 at the opening end of the gate trench 7, instead of the upper edge 23 having the oblique surface 22 of the semiconductor device 21. In other words, the upper edge 33 is not sharp, and is roundish because of the circular surface 32.

The semiconductor device 41 of the fourth embodiment shown in FIG. 4 additionally includes an interlayer film 42 formed on the plane insulating film 13 so as to cover the upper surface 16 of the gate electrode 14, besides the arrangement of the semiconductor device 31. The interlayer film 42 is made of, for example, silicon oxide (SiO₂). A contact hole 43 that continuously passes through the interlayer film 42 and through the plane insulating film 13 and by which the n⁺ type source layer 5 is selectively exposed is formed in the interlayer film 42 and in the plane insulating film 13. A source electrode (not shown) made of a conductive material, such as aluminum (Al), is embedded in the contact hole 43.

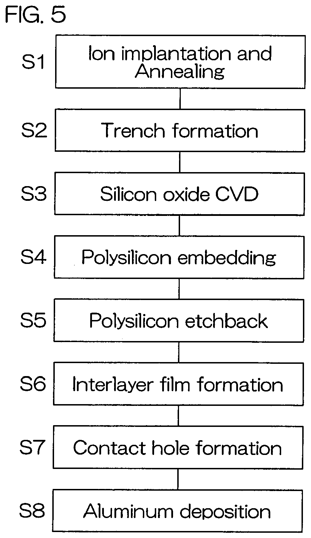

FIG. 5 is a flowchart to describe a method for manufacturing the semiconductor device 1.

In order to manufacture the semiconductor device 1, for example, impurities are selectively implanted into the surface 6 of the SiC substrate 2, and annealing is performed (step S1). As a result, impurity regions, such as the p type channel layer 4 and the n⁺ type source layer 5, are formed. Furthermore, the remaining n⁻ type region of the SiC substrate 2 is formed as the n⁻ type drain layer 3.

Thereafter, the gate trench 7 is formed in the SiC substrate 2 by etching the SiC substrate 2 from the surface 6 by means of a predetermined pattern (step S2).

The following step is to form the gate insulating film 10. In order to form the gate insulating film 10, a silicon oxide (SiO₂) is deposited in the gate trench 7 by use of a CVD method under predetermined conditions (gas flow rate, gas kind, gas ratio, gas supply time, etc.) so that parts deposited on the surface 6 of the SiC substrate 2 and on the bottom surface 8 of the gate trench 7 become selectively thicker than a part deposited on the side surface 9 of the gate trench 7 (step S3). At this time, CVD conditions are also set in consideration of the shape of the overhang portion 24 if the semiconductor devices 21, 31, and 41 of the second to fourth embodiments are manufactured. As a result, the gate insulating film 10 that integrally has the bottom insulating film 11, the side insulating film 12, and the plane insulating film 13 is formed.

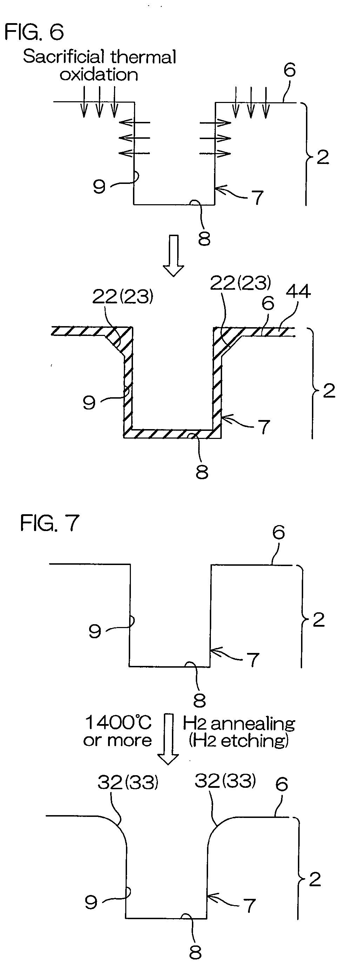

Herein, when the oblique surface 22 is formed at the upper edge 23 as shown in FIG. 2, the SiC substrate 2 is thermally oxidized after forming the gate trench 7 and before forming the gate insulating film 10. More specifically, as shown in FIG. 6, a sacrificial oxide film 44 is formed by thermally oxidizing the SiC substrate 2. When the sacrificial oxide film 44 is formed, oxidation uniformly starts from both the surface 6 of the SiC substrate 2 and the side surface 9 of the gate trench 7 near the gate trench 7. Therefore, at the upper edge 23, an oxide film that has progressed from the surface 6 of the SiC substrate 2 and an oxide film that has progressed from the side surface 9 of the gate trench 7 are formed integrally with each other earlier than in other regions. As a result, the oblique surface 22 is formed below the oxide films formed integrally with each other. Thereafter, the sacrificial oxide film 44 is removed, and it is recommended to form the gate insulating film 10 in such a manner as mentioned above (step S3).

When the technique of FIG. 6 is employed, the p type channel layer 4 and the n⁺ type source layer 5 are formed on the side of the surface 6 of the SiC substrate 2 as shown in FIG. 2, and therefore, in this part, the thermal oxidation rate becomes faster than in the n⁻ type drain layer 3, and therefore it is possible to form the oblique surface 22 more easily.

On the other hand, when the circular surface 32 is formed at the upper edge 33 as shown in FIG. 3 and FIG. 4, the SiC substrate 2 is subjected to H₂ annealing after forming the gate trench 7 and before forming the gate insulating film 10. More specifically, as shown in FIG. 7, the circular surface 32 is formed at the upper edge 33 by applying H₂ annealing (H₂ etching) to the SiC substrate 2 at 1400°C or more.

Referring again to FIG. 5, after forming the gate insulating film 10, the gate trench 7 is backfilled, and polysilicon is deposited until the whole of the gate trench 7 is concealed (step S4). Thereafter, the gate electrode 14 is formed by etchbacking the deposited polysilicon (step S5). In the semiconductor devices 21, 31, and 41 of FIG. 2 to FIG. 4, the overhang portion 24 is formed at the gate insulating film 10, and therefore the constricted portion 25 is automatically formed at the gate electrode 14 by allowing polysilicon to be deposited inside the overhang portion 24.

Thereafter, with respect to the semiconductor device 41 of FIG. 4, the interlayer film 42 is formed on the SiC substrate 2 according to the CVD method (step S6). Thereafter, the contact hole 43 is formed by applying patterning to the interlayer film 42 (step S7).

Thereafter, a metallic material, such as aluminum, is deposited on the interlayer film 42 according to a sputtering method or a vapor deposition method (step S8). As a result, a source electrode (not shown) is formed. Through these steps, it is possible to obtain the semiconductor devices 1, 21, 31, and 41 shown in FIG. 1 to FIG. 4.

According to the semiconductor devices 1, 21, 31, and 41 mentioned above, the plane insulating film 13 is thicker than the side insulating film 12 (T₁<T₃), and therefore it is possible to take an etching margin comparatively greatly when polysilicon is etched back (step S5). Therefore, when the n⁺ type source layer 5 having a thickness of from 0.05 µm to 0.5 µm is employed, it is possible to allow the gate electrode 14 to reliably overlap with the n⁺ type source layer 5 even if polysilicon is excessively etched back. This makes it possible to manufacture a semiconductor device capable of excellently performing a transistor operation, and hence makes it possible to improve a yield.

For example, when the n⁺ type source layer 5 is thin to be about 0.2 µm, there is a need to stop etchback within about 60 seconds after the etchback surface (upper surface 16) of polysilicon reaches the surface 6 of the SiC substrate 2 in order to fix the etchback surface at a place between both ends of the n⁺ type source layer 5. Therefore, in calculation, it is recommended to stop etchback within 60 seconds after it is confirmed that the etchback surface has reached the surface 6. However, the etchback surface has differences in height (in-plane variations) in a wafer plane, and therefore, even if it is possible to fix the etchback surface at a place between both ends of the n+ type source layer 5 in a region of a wafer, etching will be excessively performed in other regions, and there is a possibility that the etchback surface will reach the p type channel layer 4. Therefore, according to the present embodiment, it is possible to solve this problem by means of an etching margin that has been increased by the plane insulating film 13.

Additionally, the restraint of the thickening of the side insulating film 12 makes it possible to restrain a decrease in amount of carriers induced near the side surface 9 of the gate trench 7 in the p type channel layer 4. As a result, it is possible to restrain an increase in channel resistance, and hence is possible to maintain the reliability of performance.

Moreover, it is possible to lessen the concentration of an electric field on the bottom portion of the gate trench 7 because the bottom insulating film 11 is also thicker than the side insulating film 12 (T₁<T₂). As a result, it is possible to improve the reliability of performance.

Additionally, according to the semiconductor devices 21, 31, and 41 of the second to fourth embodiments, the overhang portion 24 is formed at the upper edges 23 and 33 of the gate trench 7, and therefore it is possible to improve the withstanding pressure of the gate insulating film 10 in the upper edges 23 and 33. Therefore, it is possible to prevent the gate insulating film 10 from causing an insulation breakdown at the upper edges 23 and 33 even if an electric field concentrates at the upper edges 23 and 33 when the gate is turned on. Particularly, the overhang portion 24 has a circular shape swelling to the inside of the gate trench 7, and therefore it is possible to evenly disperse the electric field to the whole of the overhang portion 24. As a result, it is possible to improve reliability with respect to a gate ON-state voltage. Additionally, it is possible to lessen the concentration of an electric field by dispersing the electric field applied onto the upper edges 23 and 33 in the oblique surface 22 or in the circular surface 32 when the gate is turned on.

Although the embodiment of the present invention has been described above, the present invention can be embodied in other modes.

For example, an arrangement in which the conductivity type of each semiconductor part of each semiconductor device mentioned above is reversed may be employed. For example, in the semiconductor device 1, the part of the p type may be an n type, and the part of the n type may be a p type.

The semiconductor that is employed for the semiconductor device 1 is limited to SiC.

The semiconductor device of the present invention is capable of being incorporated into a power module for use in an inverter circuit forming a driving circuit to drive an electric motor that is used as a power source of, for example, an electric automobile (including a hybrid automobile), a train, or an industrial robot. Additionally, the semiconductor device of the present invention is also capable of being incorporated into a power module for use in an inverter circuit that converts electric power generated by a solar battery, by a wind generator, or by other power generators (particularly, a private electric generator) so as to match the electric power of a commercial power source.

The embodiments of the present invention are merely concrete examples used to clarify the technical contents of the present invention, and the present invention should not be understood by being limited to these concrete examples, and the scope of the present invention is limited solely by the appended claims.

### DESCRIPTION OF THE SYMBOLS

- 1: Semiconductor device
- 2: SiC substrate
- 3: n⁻ drain layer
- 4: P type channel layer
- 5: n⁺ type source layer
- 6: Surface
- 7: Gate trench
- 8: Bottom surface
- 9: Side surface
- 10: Gate insulating film
- 11: Bottom insulating film
- 12: Side insulating film
- 13: Plane insulating film
- 14: Gate electrode
- 15: Extension portion
- 16: Upper surface
- 17: Outer peripheral part
- 21: Semiconductor device
- 22: Oblique surface
- 23: Upper edge
- 24: Overhang portion
- 25: Constricted portion
- 31: Semiconductor device
- 32: Circular surface
- 33: Upper edge
- 41: Semiconductor device
- 42: Interlayer film
- 43: Contact hole

## Claims

1. A semiconductor device (1) comprising:
a semiconductor layer (2) having a structure in which a first conductivity type drain layer (3), a second conductivity type channel layer (4), and a first conductivity type source layer (5) are layered in the stated order, the source layer (5) being exposed at a surface (6) of the semiconductor layer (2);
a gate trench (7) that passes through the source layer (5) and through the channel layer (4) from the surface (6) of the semiconductor layer (2), a deepest part of the gate trench (7) reaching the drain layer (3);
a gate insulating film (10) formed conformal to an inner surface of the gate trench (7) and the surface of the semiconductor layer (2);
a gate electrode (14) embedded inside the gate trench (7) interposed by the gate insulating film (10); and
a part (13) of the gate insulating film (10) in contact with the surface of the semiconductor layer (2) being thicker than a part (12) of the gate insulating film (10) in contact with the channel layer (4) at a side surface of the gate trench (7),
wherein the gate trench (7) includes an upper edge (23) that is formed at the opening end and that has an oblique surface (22) continuous with the surface of the semiconductor layer as a part of the side surface, and
the gate insulating film (10) includes an overhang portion (24) that projects to an inside of the gate trench (7) in the upper edge (23),
wherein the overhang portion (24) has a circular shape swelling toward the inside of the gate trench (7) when cross-sectionally viewed in a cutting plane that crosses the gate trench (7) in a width direction,
wherein the gate electrode (14) has a constricted portion that is selectively concaved in a circular shape along the overhang portion (24) when cross-sectionally viewed in the cutting plane,
wherein the gate electrode (14) has an extension portion (15) extending upwardly from the surface of the semiconductor layer (2),
wherein an upper surface (16) of the extension portion (15) is positioned at a place within the extent of the part (13) of the gate insulating film in a thickness direction of the part (13) of the gate insulating film (10) in contact with the surface of the semiconductor layer (2), **characterized in that**
the semiconductor layer (2) is made of silicon carbide,
wherein the gate insulating film (10) is integrally made of silicon oxide, and integrally includes a bottom insulating film (11) on the bottom surface (8) of the gate trench (7), a side insulating film (12) on the side surface (9) and forming the part (12) of the gate insulating film (10) in contact with the channel layer (4) at a side surface of the gate trench (7), the overhang portion (24) at the upper edge (23) of the gate trench (7) and a plane insulating film (13) on and in contact with the surface (6) of the semiconductor layer (2).

2. The semiconductor device according to claim 1, wherein a part (11) of the gate insulating film (10) in contact with a bottom surface (8) of the gate trench (7) is formed thicker than the part (12) in contact with the channel layer (4).

3. The semiconductor device according to any one of claim 1 to claim 2, further comprising an interlayer film (42) formed on the semiconductor layer (2) so as to cover the part of the gate insulating film (10) in contact with the surface of the semiconductor layer (2),
the interlayer film (42) having a contact hole (43) by which the source layer (5) is selectively exposed.

4. The semiconductor device according to any one of claim 1 to claim 3, wherein the source layer (5) has a thickness of from 1 µm to 10 µm.

5. The semiconductor device according to any one of claim 1 to claim 4, wherein the upper surface (16) of the extension portion (15) is positioned at a middle in the thickness direction of the part (13) of the gate insulating film (10) in contact with the surface of the semiconductor layer (2).

6. The semiconductor device according to any one of claim 1 to claim 3, or to claim 5 wherein the drain layer (3) has a thickness of from 1 µm to 100 µm, and has a dopant concentration of from 1×10<15>cm<-3>to 1×10<17>cm<-3>, wherein the channel layer (4) has a thickness of from 0.1 µm to 1 µm, and has a dopant concentration of from 1×10<16>cm<-3>to 1×10<20>cm<-3>, and wherein the source layer (5) has a thickness of from 0.05 µm to 0.5 µm, and has a dopant concentration of from 1×10<18>cm<-3>to 1×10<21>cm<-3>.

7. The semiconductor device according to any one of claim 1 to claim 6, wherein a thickness (T1) of the side insulating film (12) is 0.010 µm to 0.200 µm, wherein a thickness (T2) of the bottom insulating film (11) is 0.05 µm to 0.5 µm and a thickness (T3) of the plane insulating film (13) is 0.05 µm to 0.5 µm.

8. The semiconductor device of any of claims 1-3, 5, 6, 7 wherein the source layer (5) has a thickness from 0.05 µm to 0.5 µm.

9. The semiconductor device of any of claims 1 - 8, wherein the circular shape of the overhang portion leads to an electric field which is formed at the upper edge (22) when the gate is turned on, being evenly dispersed to the whole of the overhang portion (24).

## Patentansprüche

1. Halbleitervorrichtung (1), umfassend:
eine Halbleiterschicht (2) mit einer Struktur, in der eine Drainschicht (3) von einem ersten Leitfähigkeitstyp, eine Kanalschicht (4) von einem zweiten Leitfähigkeitstyp und eine Sourceschicht (5) von einem ersten Leitfähigkeitstyp in der angegebenen Reihenfolge geschichtet sind, wobei die Sourceschicht (5) an einer Oberfläche (6) der Halbleiterschicht (2) freigelegt ist;
einen Gate-Graben (7), der durch die Sourceschicht (5) und durch die Kanalschicht (4) ausgehend von der Oberfläche (6) der Halbleiterschicht (2) geht, wobei ein tiefster Teil des Gate-Grabens (7) die Drainschicht (3) erreicht;
einen Gate-Isolierfilm (10), der konform zu einer Innenfläche des Gate-Grabens (7) und der Oberfläche der Halbleiterschicht (2) ausgebildet ist;
eine Gate-Elektrode (14), die in den Gate-Graben (7) eingebettet ist, wobei der Gate-Isolierfilm (10) dazwischen eingefügt ist; und
wobei ein Teil (13) des Gate-Isolierfilms (10), der in Kontakt steht mit der Oberfläche der Halbleiterschicht (2), dicker ist als ein Teil (12) des Gate-Isolierfilms (10), der mit der Kanalschicht (4) an einer Seitenfläche des Gate-Grabens (7) in Kontakt steht,
wobei der Gate-Graben (7) eine obere Kante bzw. einen oberen Rand (23) beinhaltet, die an dem Öffnungsende ausgebildet ist und eine schräge Oberfläche (22) aufweist, die mit der Oberfläche der Halbleiterschicht als ein Teil der Seitenfläche kontinuierlich ist, und
wobei der Gate-Isolierfilm (10) einen Überhangabschnitt (24) aufweist, der zu einer Innenseite des Gate-Grabens (7) in der oberen Kante (23) ragt,
wobei der Überhangabschnitt (24) eine kreisförmige Form aufweist, die in Richtung der Innenseite des Gate-Grabens (7) anschwillt, wenn er im Querschnitt in einer Schnittebene betrachtet wird, die den Gate-Graben (7) in einer Breitenrichtung schneidet,
wobei die Gate-Elektrode (14) einen verengten Abschnitt aufweist, der selektiv in einer kreisförmigen Form entlang des Überhangabschnitts (24) verengt ist, wenn er im Querschnitt in der Schnittebene betrachtet wird,
wobei die Gate-Elektrode (14) einen Verlängerungsabschnitt (15) aufweist, der sich von der Oberfläche der Halbleiterschicht (2) nach oben erstreckt,
wobei eine obere Oberfläche (16) des Verlängerungsabschnitts (15) an einer Stelle innerhalb der Ausdehnung des Teils (13) des Gate-Isolierfilms in einer Dickenrichtung des Teils (13) des Gate-Isolierfilms (10) in Kontakt mit der Oberfläche der Halbleiterschicht (2) positioniert ist, **dadurch gekennzeichnet, dass**
die Halbleiterschicht (2) aus Siliziumkarbid hergestellt ist,
wobei der Gate-Isolierfilm (10) integral aus Siliziumoxid hergestellt ist und integral einen unteren Isolierfilm (11) auf der Bodenfläche (8) des Gate-Grabens (7), einen Seitenisolierfilm (12) auf der Seitenfläche (9), der den Teil (12) der Gate-Isolierfilm (10) bildet, der mit der Kanalschicht (4) an einer Seitenfläche des Gate-Grabens (7) in Kontakt steht, den Überhangabschnitt (24) an der oberen Kante (23) des Gate-Grabens (7) und einen ebenen Isolierfilm (13) auf und in Kontakt mit der Oberfläche (6) der Halbleiterschicht (2) beinhaltet.

2. Halbleitervorrichtung nach Anspruch 1, wobei ein Teil (11) des Gate-Isolierfilms (10), der mit einer Bodenfläche (8) des Gate-Grabens (7) in Kontakt steht, dicker ausgebildet ist als der Teil (12), der mit der Kanalschicht (4) in Kontakt steht.

3. Halbleitervorrichtung nach einem der Ansprüche 1 bis 2, ferner umfassend einen Zwischenschichtfilm (42), der auf der Halbleiterschicht (2) ausgebildet ist, um den Teil des Gate-Isolierfilms (10) abzudecken, der mit der Oberfläche der Halbleiterschicht (2) in Kontakt steht,
wobei der Zwischenschichtfilm (42) ein Kontaktloch (43) aufweist, durch das die Sourceschicht (5) selektiv freigelegt ist.

4. Halbleitervorrichtung nach einem der Ansprüche 1 bis 3, wobei die Sourceschicht (5) eine Dicke von 1 µm bis 10 µm aufweist.

5. Halbleitervorrichtung nach einem der Ansprüche 1 bis 4, wobei die obere Oberfläche (16) des Verlängerungsabschnitts (15) bei einer Mitte in der Dickenrichtung des Teils (13) des Gate-Isolierfilms (10) in Kontakt mit der Oberfläche der Halbleiterschicht (2) positioniert ist.

6. Halbleitervorrichtung nach einem beliebig der Ansprüche 1 bis 3 oder bis 5, wobei die Drainschicht (3) eine Dicke von 1 µm bis 100 µm aufweist und eine Dotierungskonzentration von 1×10<15>cm<-3> bis 1×10<17>cm<-3> aufweist, wobei die Kanalschicht (4) eine Dicke von 0,1 µm bis 1 µm aufweist und eine Dotierungskonzentration von 1×10<16>cm<-3> bis 1×10<20>cm<-3> aufweist, und wobei die Sourceschicht (5) eine Dicke von 0,05 µm bis 0,5 µm aufweist und eine Dotierungskonzentration von 1×10<18>cm<-3> bis 1×10<21>cm<-3> aufweist.

7. Halbleitervorrichtung nach einem beliebig der Ansprüche 1 bis 6, wobei eine Dicke (T1) des Seitenisolierfilms (12) 0,010 µm bis 0,200 µm beträgt, wobei eine Dicke (T2) des unteren Isolierfilms (11) 0,05 µm bis 0,5 µm beträgt und wobei eine Dicke (T3) des oberen Isolierfilms (13) 0,05 µm bis 0,5 µm beträgt.

8. Halbleitervorrichtung nach einem beliebig der Ansprüche 1 - 3, 5, 6, 7, wobei die Sourceschicht (5) eine Dicke von 0,05 µm bis 0,5 µm aufweist.

9. Halbleitervorrichtung nach einem beliebig der Ansprüche 1 - 8, wobei die kreisförmige Form des Überhangabschnitts dazu führt, dass ein elektrisches Feld, das beim Einschalten des Gates an dem oberen Rand (22) gebildet wird, gleichmäßig auf den gesamten Überhangabschnitt (24) verteilt ist.

## Revendications

1. Dispositif à semi-conducteurs (1) comprenant :
une couche semi-conductrice (2) ayant une structure dans laquelle une couche de drain d'un premier type de conductivité (3), une couche de canal d'un second type de conductivité (4) et une couche de source du premier type de conductivité (5) sont stratifiées dans l'ordre énoncé, la couche de source (5) étant exposée au niveau d'une surface (6) de la couche semi-conductrice (2) ;
une tranchée de grille (7) qui passe à travers la couche de source (5) et à travers la couche de canal (4) à partir de la surface (6) de la couche semi-conductrice (2), une partie la plus profonde de la tranchée de grille (7) atteignant la couche de drain (3) ;
un film d'isolation de grille (10) formé de manière à être conforme à une surface interne de la tranchée de grille (7) et à la surface de la couche semi-conductrice (2) ;
une électrode de grille (14) intégrée à l'intérieur de la tranchée de grille (7) intercalée par le film d'isolation de grille (10) ; et
une partie (13) du film d'isolation de grille (10) en contact avec la surface de la couche semi-conductrice (2) étant plus épaisse qu'une partie (12) du film d'isolation de grille (10) en contact avec la couche de canal (4) au niveau d'une surface latérale de la tranchée de grille (7),
dans lequel la tranchée de grille (7) comprend un bord supérieur (23) qui est formé au niveau de l'extrémité d'ouverture et qui comporte une surface oblique (22) continue avec la surface de la couche semi-conductrice en tant que partie de la surface latérale, et
le film d'isolation de grille (10) comprend une partie en surplomb (24) qui fait saillie vers un intérieur de la tranchée de grille (7) dans le bord supérieur (23),
dans lequel la partie en surplomb (24) présente une forme circulaire grossissant vers l'intérieur de la tranchée de grille (7) lorsqu'elle est vue en coupe transversale dans un plan de coupe qui croise la tranchée de grille (7) dans le sens de la largeur,
dans lequel l'électrode de grille (14) comporte une partie rétrécie qui est de manière sélective rendue concave dans une forme circulaire le long de la partie en surplomb (24) lorsqu'elle est vue en coupe transversale dans le plan de coupe,
dans lequel l'électrode de grille (14) comporte une partie d'extension (15) s'étendant vers le haut depuis la surface de la couche semi-conductrice (2),
dans lequel une surface supérieure (16) de la partie d'extension (15) est positionnée à un endroit dans le prolongement de la partie (13) du film d'isolation de grille dans le sens de l'épaisseur de la partie (13) du film d'isolation de grille (10) en contact avec la surface de la couche semi-conductrice (2), **caractérisé en ce que**
la couche semi-conductrice (2) est composée de carbure de silicium,
dans lequel le film d'isolation de grille (10) est composé intégralement d'oxyde de silicium et comprend intégralement un film d'isolation inférieur (11) sur la surface inférieure (8) de la tranchée de grille (7), un film d'isolation latéral (12) sur la surface latérale (9) et formant la partie (12) du film d'isolation de grille (10) en contact avec la couche de canal (4) au niveau d'une surface latérale de la tranchée de grille (7), la partie en surplomb (24) au niveau du bord supérieur (23) de la tranchée de grille (7) et un film d'isolation plan (13) sur la surface (6), et en contact avec cette dernière, de la couche semi-conductrice (2).

2. Dispositif à semi-conducteurs selon la revendication 1, dans lequel une partie (11) du film d'isolation de grille (10) en contact avec une surface inférieure (8) de la tranchée de grille (7) est formée plus épaisse que la partie (12) en contact avec la couche de canal (4).

3. Dispositif à semi-conducteurs selon l'une quelconque de la revendication 1 et de la revendication 2, comprenant en outre un film intercouche (42) formé sur la couche semi-conductrice (2) de sorte à recouvrir la partie du film d'isolation de grille (10) en contact avec la surface de la couche semi-conductrice (2),
le film intercouche (42) comportant un trou de contact (43) par lequel la couche de source (5) est exposée de manière sélective.

4. Dispositif à semi-conducteurs selon l'une quelconque de la revendication 1 à la revendication 3, dans lequel la couche de source (5) présente une épaisseur comprise entre 1 µm et 10 µm.

5. Dispositif à semi-conducteurs selon l'une quelconque de la revendication 1 à la revendication 4, dans lequel la surface supérieure (16) de la partie d'extension (15) est positionnée au milieu dans le sens de l'épaisseur de la partie (13) du film d'isolation de grille (10) en contact avec la surface de la couche semi-conductrice (2).

6. Dispositif à semi-conducteurs selon l'une quelconque de la revendication 1 à la revendication 3, ou à la revendication 5, dans lequel la couche de drain (3) présente une épaisseur comprise entre 1 µm et 100 µm et présente une concentration de dopant comprise entre 1 x 10¹⁵ cm⁻³ et 1 x 10¹⁷ cm⁻³, dans lequel la couche de canal (4) présente une épaisseur comprise entre 0,1 µm et 1 µm et présente une concentration de dopant comprise entre 1 x 10¹⁶ cm⁻³ et 1 x 10²⁰ cm⁻³ et dans lequel la couche de source (5) présente une épaisseur comprise entre 0,05 µm et 0,5 µm et présente une concentration de dopant comprise entre 1 x 10¹⁸ cm⁻³ et 1 x 10²¹ cm⁻³.

7. Dispositif à semi-conducteurs selon l'une quelconque de la revendication 1 à la revendication 6, dans lequel une épaisseur (T1) du film d'isolation latéral (12) est comprise entre 0,010 µm et 0,200 µm, dans lequel une épaisseur (T2) du film d'isolation inférieur (11) est comprise entre 0,05 µm et 0,5 µm et une épaisseur (T3) du film d'isolation plan (13) est comprise entre 0,05 µm et 0,5 µm.

8. Dispositif à semi-conducteurs selon l'une quelconque de revendications 1 à 3, 5, 6, 7, dans lequel la couche de source (5) présente une épaisseur comprise entre 0,05 µm et 0,5 µm.

9. Dispositif à semi-conducteurs selon l'une quelconque de la revendication 1 à 8, dans lequel la forme circulaire de la partie en surplomb conduit à un champ électrique qui est formé au niveau du bord supérieur (22) lorsque la grille est mise sous tension, qui est réparti de manière uniforme sur la totalité de la partie en surplomb (24).
